Europäisches Patentamt

European Patent Office

Office européen des brevets

(11) Veröffentlichungsnummer: **0 394 525**
**A1**

## (12) EUROPÄISCHE PATENTANMELDUNG

(21) Anmeldenummer: 89107627.5

(22) Anmeldetag: 27.04.89

(51) Int. Cl.5: **G01R 31/02, G01R 31/12**

(43) Veröffentlichungstag der Anmeldung:
**31.10.90 Patentblatt 90/44**

(84) Benannte Vertragsstaaten:
**CH DE FR GB IT LI**

(71) Anmelder: **Siemens Aktiengesellschaft**

Wittelsbacherplatz 2
**D-8000 München 2(DE)**

(72) Erfinder: **Richter, Martin, Dipl.-Ing.(FH)**
**Schulstrasse 20**
**D-8525 Marloffstein(DE)**

(54) **Verfahren und Vorrichtung zum berührungslosen Überprüfen der Isolation von isolierten elektrischen Leitern sowie zur Erkennung und Klassifizierung von Isolationsfehlern.**

(57) Die bisher bekannten und in der Praxis angewandten Verfahren zum Überprüfen der Isolation von isolierten elektrischen Leitern arbeiten noch nicht zufriedenstellend. Erfindungsgemäß wird ein Verfahren mit folgenden Merkmalen vorgeschalgen:
- Der Leiter läuft axial durch wenigstens zwei hintereinanderliegende ringförmige Sonden, die jeweils Kondensatoren mit dem Leiter als Gegenpol bilden, wobei die Kondensatoren mittels wenigstens einer Spannungsquelle derart aufgeladen werden, daß bei Fehlern in der Isolation der Kondensator von einem Durchschlagstrom kurzgeschlossen wird,
- durch Erfassen der Überschläge und deren Auswertung an den einzelnen Kondensatoren werden jeweils ortsspezifische Signale in Korrelation mit dem Vorschub des Leiters gewonnen,
- durch logische Verknüpfung der ortsspezifischen Signale an den einzelnen Kondensatoren werden Prüfgrößen für die Längenausdehnung der Isolationsfehler abgeleitet.

Bei der zugehörigen Vorrichtung bilden die Sonden voneinander isolierte Teilkondensatoren (11, 12, 13) eines Rohrkondensators (10), die gleiche Länge (L) und in Achsrichtung nur einen geringen Abstand (d) haben, wobei die äußeren Teilkondensatoren (11, 13) beim Ein- bzw. Auslauf (11a, 12a) des Leiters (1) so geformt sind, daß sich eine gleichbleibende Feldverteilung ergibt.

FIG 2

EP 0 394 525 A1

Die Erfindung bezieht sich auf ein Verfahren zum berührungslosen Überprüfen der Isolation von isolierten elektrischen Leitern sowie zur Erkennung und Klassifizierung von Isolationsfehlern. Daneben bezieht sich die Erfindung auch auf die zugehörige Vorrichtung zur Durchführung des Verfahrens.

Isolierte elektrische Leiter werden in unterschiedlichster Ausbildung und Qualitätsanforderungen benötigt. Derartige Leiter können aus einer einzigen isolierten Ader oder auch mehreren Adern bestehen, die einen gemeinsamen Isolationsmantel haben und somit Kabel oder Leitungen bilden. Hergestellt werden derartige Leitungen üblicherweise durch Extrusion. Bei der Aderextrusion können Fehler in der extrudierten Isolationsschicht auftreten. Zum größten Teil haben derartige Fehler nur die Größe von Poren, welche unter bestimmten Voraussetzungen toleriert werden können. Für eine Nachbearbeitung bzw. Reparatur einer Ader ist die Kenntnis über Fehlerart und Fehlergröße sowie deren örtliche Lage von Wichtigkeit.

Es ist bereits üblich, zur Verbesserung der Qualität isolierter elektrischer Leiter und zur Rationalisierung bei der Herstellung, die verwendeten Extrusionslinien meßtechnisch auf umfangreicherweise zu überwachen und zu steuern. Zu den hierfür verwendeten Meßgeräten gehören unter anderem ein sogenannter Trockenprüfer (Sparktester) zur Prüfung der Isolierung auf Fehlstellen und Meßgeräte zur Prüfung der Oberfläche des isolierten elektrischen Leiters (Surfacetester). Bei den Oberflächenmeßgeräten kann es sich insbesondere um ein Durchmessermeß gerät, um einen sogenannten Knotenwächter oder um ein Oberflächenfehlerprüfgerät handeln.

Aus der älteren deutschen Patentanmeldung P 38 33 165.9 ist ein Verfahren zur Erfassung von Isolationsfehlern an kunststoffisolierten elektrischen Leitern bekannt, bei dem aufgrund einer elektrischen Prüfung der Isolierung und aufgrund einer Oberflächenprüfung der Isolierung jeweils ein Meßsignal erzeugt und diese Meßsignale ausgewertet werden, wobei das Meßsignal die elektrische Prüfung und das für denselben Oberflächenabschnitt der Isolierung erzeugte Meßsignal der Oberflächenprüfung einer Logikstufe zugeführt werden, welche die beiden Meßsignale miteinander verknüpft, daß im Falle des Vorhandenseins beider Meßsignale ein zusätzliches Ausgangssignal erzeugt wird.

Weiterhin ist aus der EP-A-0 006 494 ein Verfahren und eine Vorrichtung zum berührungslosen Überprüfen der Isolation bewegter isolierter Leiter bekannt, bei der der Draht axial durch eine ringförmige Sonde geführt wird, die einen Kondensator mit dem Draht als Gegenpol bildet. Ein Isolationsfehler ruft dabei einen elektrischen Überschlag zwischen Sonde und Draht hervor. An die Sonde ist der eine Pol eines Koppelkondensators angeschlossen, der bei Durchschlag auf das Potential des Drahtes gelegt wird. Dadurch entsteht am anderen Pol des Koppelkondensators ein Spannungsimpuls und ein Verschiebestrom der erfaßt und angezeigt wird.

Erprobungen haben ergeben, daß die vom Stand der Technik vorgeschlagenen Geräte noch nicht den Bedürfnissen der Praxis genügen. Aufgabe der Erfindung ist es daher, ein weiteres Verfahren mit der zugehörigen Vorrichtung anzugeben, mit dem eindeutige Rückschlüsse auf Ort und Länge von Isolationsfehlern gemacht werden können.

Erfindungsgemäß gelingt dies mit folgenden Verfahrensmerkmalen:
- Der Leiter läuft axial durch wenigstens zwei hintereinanderliegende ringförmige Sonden, die jeweils Kondensatoren mit dem Leiter als Gegenpol bilden, wobei die Kondensatoren mittels wenigstens einer Spannungsquelle derart aufgeladen werden, daß bei Fehlern in der Isolation der Kondensator von einem Durchschlagstrom kurzgeschlossen wird,
- durch Erfassen der Überschläge und deren Auswertung an den einzelnen Kondensatoren werden jeweils ortsspezifische Signale in Korrelation mit dem Vorschub des Leiters gewonnen,
- durch logische Verknüpfung der ortsspezifischen Signale an den einzelnen Kondensatoren werden Prüfgrößen für die Längenausdehnung der Isolationsfehler abgeleitet.

Mit dem vorgeschlagenen Verfahren sind in vorteilhafter Weise die Längenausdehnungen der Isolationsfehler hinsichtlich Porenfehler ohne Ausdehnung, kurze Fehler mit Ausdehnungen $0 < l_r < 3mm$ und lange Fehler mit Ausdehnungen $3mm < l_r < \infty$ diskriminierbar. Dabei werden pro Längenschritt alle Überschläge erfaßt und registriert, wobei mindestens jeweils ein Überschlag ortsspezifisch ausgewertet wird.

In praktischer Realisierung bilden bei einer Vorrichtung zur Durchführung des erfindungsgemäßen Verfahrens die Sonden voneinander isolierte Teilkondensatoren eines Rohrkondensators, die gleiche Länge und in Achsrichtung nur einen geringen Abstand haben, wobei die Teilkondensatoren beim äußeren Ein- bzw. Auslauf des Leiters so geformt sind, daß sich eine gleichbleibende Feldverteilung (Rogowski-Kontur) ergibt. Insbesondere kann dabei ein einziger Hochspannungsgenerator als Spannungsquelle für die Teilkondensatoren dienen und sind in die Anschlußleitungen der Teilkondensatoren HF-Stromwandler geschaltet.

Insbesondere durch Verwendung eines Rohrkondensators mit drei Teilkondensatoren und Speicherung der während des Durchlaufs eines Isolationsfehlers auftretenden Überschläge in jedem Kondensatorteil kann aus der Konstellation der teilebezogenen Überschläge die tatsächliche Fehlerlänge errechnet und längenzugeordnet angezeigt werden. Hierzu ist vorteilhafterweise ein Personalcomputer mit zugehörigen Endgeräten vorhanden. Durch geeignete softwaremäßige Ablaufsteuerung können nach Ermittlung, Diskriminierung und Anzeige des jeweiligen Fehlers durch Rückkopplung der Daten zum Reparatur- und Umwickelstand die zu reparierenden Fehlstellen automatisch aufgefunden werden.

Weitere Einzelheiten und Vorteile der Erfindung ergeben sich aus der nachfolgenden Figurenbeschreibung eines Ausführungsbeispiels. Es zeigen

FIG 1 einen isolierte elektrischen Leiter im Seitenriß und Querschnitt zur Verdeutlichung der unterschiedlichen Fehlertypen,

FIG 2 den schematischen Aufbau der vorgeschlagenen Sonde zusammen mit den Einheiten zur Versorgung und Meßwerterfassung und

FIG 3 als Blockschaltbild die Einheiten zum Zählen und Zwischenspeichern der ortsspezifischen Signale zusammen mit den zugehörigen Auswertemitteln.

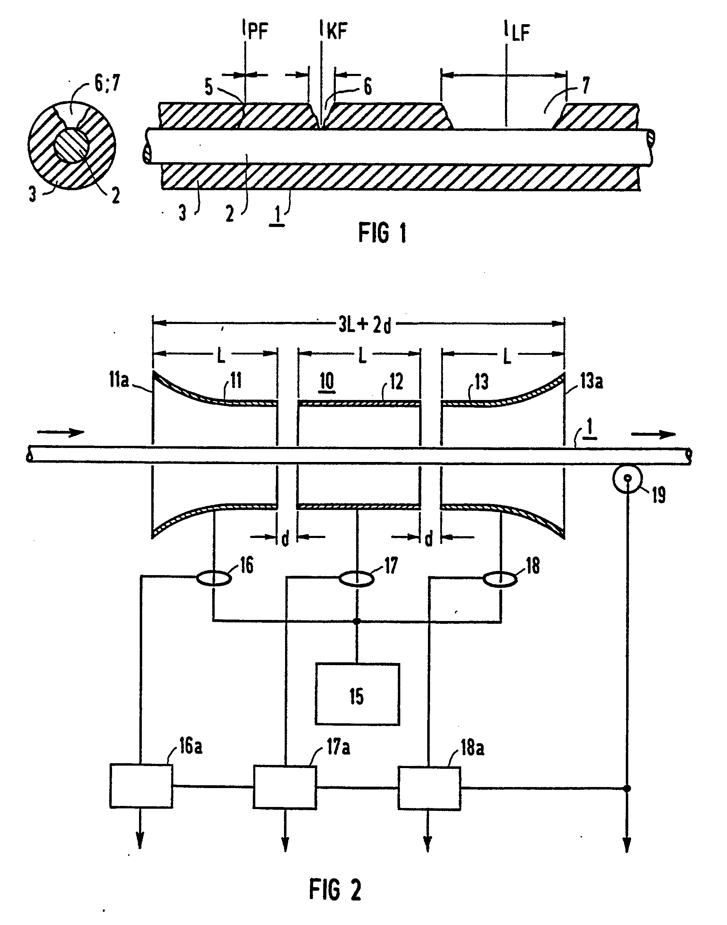

In FIG 1 ist eine isolierte elektrische Leitung 1 dargestellt, die aus dem eigentlichen metallischen Leiter 2 und der Isolationsschicht 3 besteht. Derartige Leitungen können in unterschiedlicher Weise je nach den entsprechenden Anforderungen ausgestaltet sein. Beispielsweise kann es sich um eine einzige isolierte metallische Ader handeln, wie in FIG 1 dargestellt; es können auch mehrere Adern, die jeweils für sich isoliert sind, zu einer mehradrigen Leitung verdrillt und mit einer gemeinsamen Isolationsschicht versehen sein.

Die Herstellung derartiger Leitungen 1 erfolgt durch Aufextrusion von Isoliermaterial auf den metallischen Draht. Die Isoliermaterialien können Silikongummi und/oder Kunststoffe sein und sind auf die Anforderungen bei Verwendung der Leitung abgestellt.

In FIG 1 ist ein sogenannter Porenfehler 5 vorhanden, der an der Oberfläche praktisch keine Ausdehnung hat, aber einen Strompfad zur Ader 2 realisiert. Derartige Porenfehler (PF) können im allgemeinen dann toleriert werden, wenn sichergestellt ist, daß bei dem späteren bestimmungsmäßigen Gebrauch der Leitung nicht zwei derartige Porenfehler aufeinander zu liegen kommen. Ein sogenannter kurzer Fehler 6 hat eine vorgegebene maximale Längsausdehnung als Obergrenze, die im vorliegenden Fall mit 3 mm definiert ist. Längere Fehler, wie beispielsweise Fehler 7 in FIG 1, werden als sogenannte lange Fehler definiert.

Letztere Isolationsfehler können unterschiedliche geometrische Ausformungen radial zur metallischen Ader haben, was im Schnittbild angedeutet ist; weiterhin können die kurzen Fehler (KF) und die langen Fehler (LF) neben der axialen Ausdehnung auch eine Ausdehnung azimutal über den Umfang der Leitung haben.

Gemäß VDE-Vorschriften (VDE 042, Teil 514) müssen Kabel und isolierte Leitungen auf Fehler in der Isolierhülle geprüft werden. Dabei wird gefordert, daß alle potentiellen Fehler von einer diesbezüglichen Prüfeinrichtung registriert werden, was sich jedoch in der Praxis beispielsweise wegen der Erholzeiten der bekannten Prüfgeräte als schwierig erweist, wenn beispielsweise zwei Fehler bei schnellem Durchlauf der Leitung durch eine Sonde in geringem Abstand hintereinander auftreten.

In FIG 2 durchläuft die Leitung 1 aus FIG 1 einen Rohrkondensator 10, der aus drei Teilkondensatoren 11, 12 und 13 besteht. Dabei haben die Teilkondensatoren 11, 12 und 13 die gleiche axiale Länge, die zwischen 30 und 100 mm liegen kann. Sie sind voneinander isoliert aufgebaut und haben zueinander in Aderlaufrichtung nur einen geringen Abstand, damit sie vom selben Hochspannungsgenerator 15, beispielsweise mit 7 kHz und einer Spannung zwischen 10 und 30 kV, gespeist werden können. Jeweils die beiden äußeren Teilkondensatoren 11 und 13 sind beim Ein-bzw. Auslauf 11a bzw. 13a für die Leitung 1 so geformt, daß sich eine gleichbleibende Feldverteilung ergibt. Derartige Ausformungen sind als sogenannte Rogowski-Konturen bekannt.

Die Versorgungsleitungen der Teilkondensatoren 11 bis 13 werden mittels HF-Stromwandler 16 bis 18 auf Stromfluß überwacht. Die Stromwandler werden vorteilhafterweise durch ringförmige Ferritkerne mit Wicklung um die Spannungsversorgungsleitungen realisiert, in die bei Stromfluß Spannungen induziert werden und den jeweils eine Pulsformerstufe 16a bis 18a nachgeschaltet sind. Dadurch steht im Fall eines elektrischen Überschlages, der bei einem Fehler in der Leitung von der Hochspannung der Kondensatoren hervorgerufen wird, jeweils ein Trägersignal zur Verfügung, das elektronisch weiterverarbeitet werden kann. Ein Längenimpulsgeber 19 gibt beispielsweise als Millimeterrad im Abstand von 1 mm inkrementale Zählimpulse ab, wodurch eine ortsbezogene Speicherung der Überschläge möglich wird. Es sind auch kleinere Längenschritte bis zu 0,1 mm möglich.

Wenn eine Leitung 1 durch den Rohrkondensator 10 mit hoher Geschwindigkeit läuft, werden bei Vorliegen von Isolationsfehlern nacheinander bzw. parallel Überschläge von den Teilkondensatoren 11, 12 und 13 zur Leitung auftreten. Dabei werden bei einem Porenfehler im Idealfall bei Durchlauf der Leitung 1 durch den Rohrkondensator 10 Überschläge zunächst nur am ersten Teilkondensator 11, anschließend am zweiten Teilkondensator 12 und schließlich nur am dritten Teilkondensator 13 auftreten. Bei axial ausgedehnten Isolationsfehlern, d.h. sowohl bei kurzen Fehleren (KF) als auch bei langen Fehlern (LF), treten in bestimmten Überlappungsbereichen gleichzeitig Überschläge an zwei oder auch an allen drei Teilkondensatoren auf.

Im praktischen Betrieb kann es allerdings durch Nässe oder dergleichen beispielsweise zum Vorziehen und/oder zum Nachziehen von Überschlägen kommen, so daß auch bei Porenfehlern gleichzeitige Überschläge an den Teilkondensatoren auftreten können. Weiterhin kann es auch zu Zündansetzern kommen, bei denen ein oder mehrere eigentlich zu erwartende Überschläge nicht auftreten. Bei gleichzeitigem Auftreten derartiger Fehler folgen daraus erhebliche Abweichungen vom Idealzustand. Es ergeben sich jeweils ganz spezifische Muster für unterschiedlichste Fehlerkonstellationen, die aber mittels eines Rechners durch logische Verknüpfungen erfaßbar und den einzelnen Fehlerarten zugeordbar sind.

Aufgrund der unterschiedlichen Muster kann also nunmehr eindeutig zwischen Porenfehlern (PF) einerseits und kurzen Fehlern (KF) sowie langen Fehlern (LF) andererseits unterschieden werden, worauf weiter unten noch im einzelnen eingegangen wird. Daneben kann die Fehlerfolge bzw. der Fehlerfolgeabstand erfaßt werden.

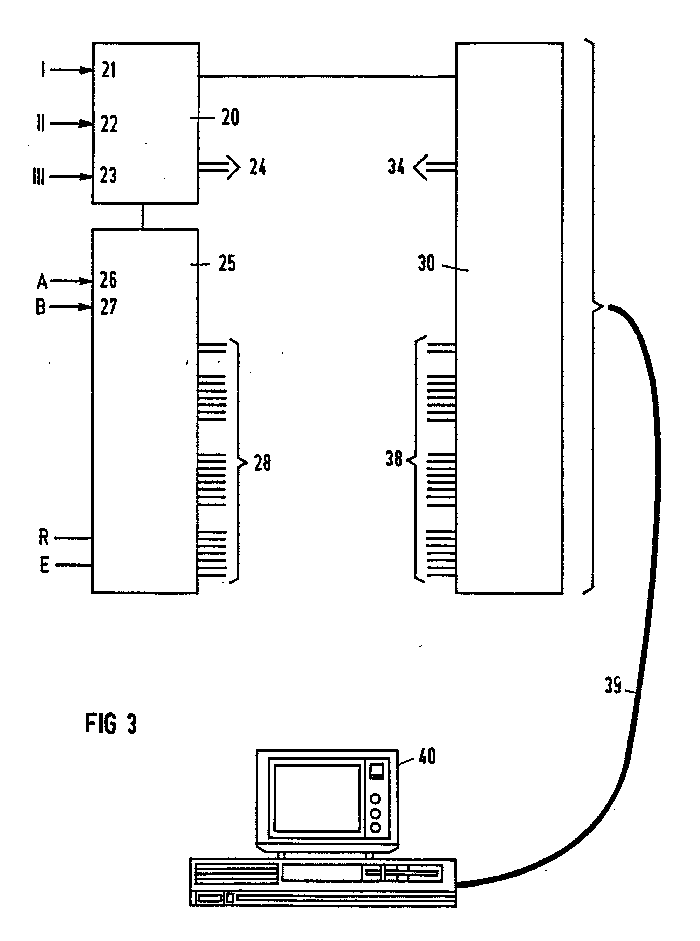

In FIG 3 ist ein erster Speicher 20 mit Eingängen 21 bis 23 für Überschläge I, II und III vorhanden, dem ein üblicher 26-Bit-Zähler 25 für Zählimpulse A und B zugeordnet ist und dem ein zweiter 32-Bit-Speicher mit 16 K Tiefe nachgeschaltet ist. Es sind jeweils Mittel 24 bzw. 34 zur Elektrodenkennung sowie 28 und 38 zur 26-Bit-Positionscodierung vorhanden. Der Speicher 30 ist über einen Lichtwellenleiter 39 mit einem Personal-Computer 40 verbunden, der zur Auswertung der Signale und Steuerung eines eventuellen Reparaturvorganges dient.

Die Zählimpulse des Millimeterrades 19 aus FIG 2 werden auf den Zähler 25 geleitet, der mit 26 Bit eine Aderlänge von über 60 km in Millimeterschritten aufnehmen kann. Die Triggersignale der Stromwandler 16 bis 18 für die einzelnen Teilkondensatoren 11 bis 13 gemäß FIG 2 gehen zunächst auf die Zwischenspeicherstufe 20, die gewährleistet, daß Mehrfachüberschläge innerhalb eines Längenschrittes nur einmal bewertet werden. Jeweils beim Weiterschalten zum nächsten Schritt wird der Inhalt des Speichers 20 mit den eventuellen Überschlagsereignissen in den Speicher 30 übertragen und unter der jeweiligen Schrittnummer abgelegt. Im Speicher 30 können bei einer Länge der Teilkondensatoren 11 bis 13 von beispielsweise 20 mm insgesamt 16 m fehlerhafte Ader entsprechend einer blanken Ader oder 800 verschiedene Porenfehler abgespeichert werden.

Die gespeicherten Informationen werden mittels des Lichtwellenleiters 39 zum Personalcomputer 40 übertragen und dort ausgewertet. Von hier kommt unmittelbar nach Beendigung des Fertigungsvorganges ein optisches Signal, ob die gefertigte Trommel nur tolerierbare Porenfehler enthält, oder ob sie zum Umwickelstand muß, um dort repariert zu werden. Dabei steuert der PC 40 gleichermaßen das Rückwickeln der Trommel bis zum lokalisierten Fehler.

Durch die parallele Erfassung der Überschläge lassen sich die unterschiedlichen Fehler diskriminieren. Es läßt sich näherungsweise folgende Beziehung angeben:

$$\Delta l_F = n \cdot (k + l_s) \pm 1,$$

wobei $\Delta l_F$ die Längenausdehnung des Fehlers in mm, n eine Folge von Längenschritten, bei der in einem der Teilkondensatoren 11 bis 13 ein Überschlag stattfand, k die Ausdehnung der Kondensatorteile in Längenschritten und $l_s$ ein diskreter Längenschritt bedeuten. Die Toleranzabweichung von ± 1 ergibt bei drei Teilkondensatoren eine eindeutige Diskriminierung der unterschiedlichen Fehlerarten.

Praktische Untersuchungen haben ergeben, daß sich mit der Vorrichtung gemäß FIG 2 in Verbindung mit der Auswerteeinheit gemäß FIG 3 alle relevanten Fehler diskriminieren lassen. Es ist dafür Sorge getragen, daß pro Längenschritt alle Überschläge erfaßt und registriert werden, wobei mindestens jeweils ein Überschlag ortsspezifisch ausgewertet wird. Durch die entsprechende softwaremäßige Auswertung im Personalcomputer 40 können Fehldeutungen ausgeschaltet werden.

Neben normalen Porenfehlern (PF), kurzen Fehlern (KF) und langen Fehlern (LF) können insbesondere auch Isolationsfehler mit folgenden Nebenbedingungen diskriminiert werden:

- Porenfehler mit Vor- und Nachziehen durch Nässe,
- zwei Porenfehler im Abstand von beispielsweise 15 mm, wobei eine Pore einen Zündaussetzer bewirken kann,
- 5 mm-Schlitzung mit Vorzünden und ausgeprägter Überschlagszone,
- 3 mm-Fehler mit ausgeprägter Überschlagszone,
- 5 mm-Fehler mit verteilter Überschlagsneigung,
- 18 mm-Fehler mit bevorzugter Überschlagszone am Anfang,
- Langfehler entsprechend der Kondensatorlänge.

Versuche haben gezeigt, daß bei den oben dargestellten Konstellationen durch die Rechnerauswertung immer eine optimale Bewertung der Fehlerlänge möglich ist, wenn der Personal-Computer 40 nacheinander die pro Teilkondensator aufgezeichneten Ereignisse bewertet und dann erst die Entscheidung über die Art des Fehlers trifft.

## Ansprüche

1. Verfahren zum berührungslosen Überprüfen der Isolation von isolierten elektrischen Leitern sowie zur Erkennung und Klassifizierung von Isolationsfehlern mit folgenden Verfahrensmerkmalen:

- Der Leiter läuft axial durch wenigstens zwei hintereinanderliegende ringförmige Sonden, die jeweils Kondensatoren mit dem Leiter als Gegenpol bilden; wobei die Kondensatoren mittels wenigstens einer Spannungsquelle derart aufgeladen werden, daß bei Fehlern in der Isolation der Kondensator von einem Durchschlagstrom kurzgeschlossen wird,

- durch Erfassen der Überschläge und deren Auswertung an den einzelnen Kondensatoren werden jeweils ortsspezifische Signale in Korrelation mit dem Vorschub des Leiters gewonnen,

- durch logische Verknüpfung der ortsspezifischen Signale an den einzelnen Kondensatoren werden Prüfgrößen für die Längenausdehnung der Isolationsfehler abgeleitet.

2. Verfahren nach Anspruch 1, **dadurch gekennzeichnet**, daß die Längenausdehnungen der Isolationsfehler hinsichtlich Porenfehler ohne Ausdehnung (PF), kurze Fehler (KF) mit Ausdehnungen $0 < l_F < 3mm$ und lange Fehler (LF) mit Ausdehnungen $3mm < l_F < \infty$ diskriminierbar sind.

3. Verfahren nach Anspruch 1 und 2, **dadurch gekennzeichnet**, daß pro Längenschritt alle Überschläge erfaßt und registriert werden, wobei mindestens jeweils ein Überschlag ortsspezifisch ausgewertet wird.

4. Verfahren nach Anspruch 1, **dadurch gekennzeichnet**, daß die Ader und/oder Leitung durch einen Rohrkondensator läuft, der aus drei benachbarten Kondensatorteilen besteht, und daß die ortsspezifischen Signale der drei Kondensatorteile in einem Rechner verarbeitet werden und die Berechnung der Längenausdehnung der Isolationsfehler nach der Beziehung erfolgt

$$\Delta l_F = n - (k + l_s) \pm 1,$$

wobei $\Delta l_F$ die Längenausdehnung des Fehlers in mm, n eine Folge von Längenschritten, bei der in einem der Kondensatorteile ein Überschlag stattfand, k die Ausdehnung der Kondensatorteile in Längenschritten und $l_s$ ein diskreter Längenschritt bedeuten. .

5. Verfahren nach Anspruch 1, **dadurch gekennzeichnet**, daß eine ortsbezogene Speicherung der Isolationsfehler durch Abspeicherung von Überschlagimpulsen auf einem Zähler und Zuordnung der Isolationsfehler zu den WegLängenschritten erfolgt.

6. Verfahren nach Anspruch 1, **dadurch gekennzeichnet**, daß von den einzelnen Teilkondensatoren bei Auftreten eines Überschlages Triggersignale auf eine Zwischenspeicherstufe gegeben werden.

7. Verfahren nach Anspruch 6, **dadurch gekennzeichnet**, daß in der Zwischenspeicherstufe eine Synchronisation der Prüfsignale der einzelnen Teilkondensatoren in der Weise erfolgt, daß mehrfach Überschläge innerhalb eines Längenschrittes nur einmal bewertet werden.

8. Verfahren nach Anspruch 6 und 7, **dadurch gekennzeichnet**, daß mit jedem Längenschritt der Speicherinhalt vom Zwischenspeicher in einen Fehlerspeicher übertragen und dort unter dem zugehörigen Längenschritt abgespeichert wird.

9. Verfahren nach Anspruch 8, **dadurch gekennzeichnet**, daß die im Speicher gespeicherten Informationen in einen Personalcomputer als Rechner übermittelt und dort ausgewertet werden.

10. Verfahren nach Anspruch 2 und 9, **dadurch gekennzeichnet**, daß bei Erkennen von langen Fehlern (LF) der Fertigungsvorgang unterbrochen und der Leitungswickel rechnergesteuert zum Fehlerort zwecks Reparatur zurückgespult werden.

11. Vorrichtung zur Durchführung des Verfahrens nach Anspruch 1 oder einem der Ansprüche 2 bis 10, bei der ein sich in axialer Richtung bewegender isolierter elektrischer Leiter wenigstens zwei ringförmige Sonden, die als Kondensator mit dem Leiter als Gegenpol geschaltet und mit einer Hochspannungsquelle verbunden sind, durchläuft, wobei die Sonde voneinander isolierte Teilkondensatoren (11, 12, 13) eines Rohrkondensators (10) bilden, die gleiche Länge (L) und in Achsrichtung nur einen geringen Abstand (d) haben und wobei die Teilkondensatoren (11, 13) beim äußeren Ein- bzw. Auslauf (11a, 12a) des Leiters (1) so geformt sind, daß sich eine gleichbleibende Feldverteilung (Rogowski-Kontur) ergibt.

12. Vorrichtung nach Anspruch 11, **dadurch gekennzeichnet**, daß der Rohrkondensator (10) drei oder mehr Teilkondensatoren (11 bis 13) bildet.

13. Vorrichtung nach Anspruch 11 oder 12, **dadurch gekennzeichnet**, daß ein einziger Hochspannungsgenerator (15) als Spannungsquelle für die Teilkondensatoren (11, 12, 13) dient und daß in die Anschlußleitungen der Teilkondensatoren HF-Stromwandler (16-18) geschaltet sind.

14. Vorrichtung nach Anspruch 13, **dadurch gekennzeichnet,** daß die HF-Stromwandler (16 bis 18) ringförmige drahtbewickelte Ferritkerne sind, denen jeweils eine Pulsformstufe nachgeschaltet ist.

15. Vorrichtung nach Anspruch 11 oder 12, **dadurch gekennzeichnet**, daß jedem Teilkondensator (11, 12, 13) ein eigener Hochspannungsgenerator zugeordnet ist.

16. Vorrichtung nach Anspruch 11, **dadurch gekennzeichnet**, daß ein Längenimpulsgeber (14) vorhanden ist, der im Abstand $0,1\ mm \leq l_s \leq 1\ mm$ inkrementale Zählimpulse abgibt, die auf einen digitalen Zähler (25), vorzugsweise einen 26 Bit-Zähler, geleitet werden.

17. Vorrichtung nach Anspruch 11, **dadurch gekennzeichnet**, daß ein erster Speicher (20), der als Zwischenspeicherstufe für die Triggersignale und deren Synchronisation dient, und ein zweiter Speicher (30) für die positionsgenaue Abspeicherung der Triggersignale vorhanden sind.

18. Vorrichtung nach Anspruch 17, **dadurch gekennzeichnet**, daß die Speicher (20, 30) über einen Lichtwellenleiter (39) an einen Personalcomputer (40) angekoppelt sind.

19. Vorrichtung nach Anspruch 18, **dadurch gekennzeichnet**, daß der Personalcomputer (40) zur Diskriminierung und Anzeige der Isolationsfehler ausgelegt ist sowie gleichermaßen einen Reparatur- und Umwickelstand für den Leiter bei Vorliegen eines temperaturbedürftigen Isolationsfehlers steuert.

EP 0 394 525 A1

FIG 1

FIG 2

I → 21

II → 22

20

III → 23

24

34

A → 26

25

B → 27

30

28

38

R

E

FIG 3

40

39

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | US-A-3 789 295 (BALCHUNAS et al.) * Zusammenfassung; Figur 1 * | 1-3 | G 01 R 31/02 G 01 R 31/12 |
| A | | 10,11, 19 | |
| Y | DE-A-2 500 438 (BAUM) * Seite 2, Absatz 3; Figur 3 * | 1-3 | |
| A | | 11,15 | |
| A | DE-A-2 435 727 (FELTEN & GUILLEAUME) * Seite 1, Absatz 1; Seite 3, Absatz 1 - Seite 4, Absatz 3; Figuren 1,2 * | 1,5-9, 11 | |
| A | DE-A-2 026 405 (BRITISH INSULATED CALLENDERS'S CABLES) * Seite 1, Absatz 1 - Seite 2, Absatz 1; Seite 3, Absatz 4; Seite 4, Absatz 1; Seite 5, Absatz 3; Figuren 2,4 * | 1-3,11 | |
| D,A | EP-A-0 006 494 (SIEMENS) * Seite 4, Zeile 24 - Seite 5, Zeile 27; Seite 10, Zeilen 10-14; Figur 1 * | 1,11,13 | |

**RECHERCHIERTE SACHGEBIETE (Int. Cl.5)**

G 01 R
H 01 B

Der vorliegende Recherchenbericht wurde für alle Patentansprüche erstellt

| Recherchenort | Abschlußdatum der Recherche | Prüfer |
|---|---|---|
| DEN HAAG | 22-12-1989 | SINAPIUS G.H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

.............................................................................

& : Mitglied der gleichen Patentfamilie, übereinstimmendes Dokument

EPO FORM 1503 03.82 (P0403)